Europäisches Patentamt

European Patent Office

Office européen des brevets

(19)

(11) Publication number: **0 325 401**
**A2**

(12) # EUROPEAN PATENT APPLICATION

(21) Application number: **89300389.7**

(22) Date of filing: **17.01.89**

(51) Int. Cl.4: **B 41 F 15/08**

(30) Priority: **18.01.88 JP 6786/88**
**28.04.88 JP 103900/88**
**06.06.88 JP 137448/88**

(43) Date of publication of application:
**26.07.89 Bulletin 89/30**

(84) Designated Contracting States:
**AT BE DE FR GB IT NL SE**

(71) Applicant: **Oozeki, Masanao**
**47-6-301 Sakuradai 3-chome**
**Nerimaku Tokyo (JP)**

(72) Inventor: **Oozeki, Masanao**
**47-6-301 Sakuradai 3-chome**
**Nerimaku Tokyo (JP)**

(74) Representative: **Brunner, Michael John et al**
**GILL JENNINGS & EVERY 53-64 Chancery Lane**
**London WC2A 1HN (GB)**

(54) **Improved screen printing machine.**

(57) The screen stencil printing machine according to the present invention has a screen stencil having its one end resiliently movably held for movement in sychronization with the squeegee in sweep across the screen stencil so as t keep constant the tention the squeegee exerts on the screen stencil.

In a first preferred embodiment of the invention. one end of the screen stencil is resiliently movably connected to a fixed point, with the screen stencil opposite end being secured to a fixed position.

With this arrangement, the tension that the squeegee exerts on the screen stencil is maintained constant, becouse of the movement of the resiliently held screen stencil end in timed relation with the squeegee.

FIG.3(a)

EP 0 325 401 A2

## Description

### IMPROVED SCREEN PRINTING MACHINE

This invention relates to a performance improvement in screen printing apparatus.

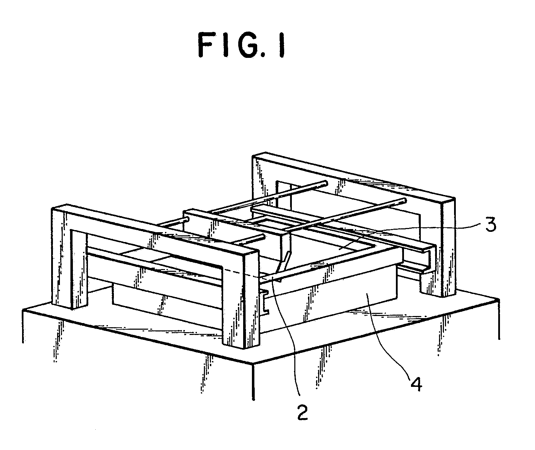

In screen printing, a fine-meshed web 1 stretched in a taut state on a wooden or metal frame 4 is formed into a box-like screen, as depicted in Fig. 1. The desirable pattern is applied directly to the screen mesh by painting it with an impermeable medium. The screen stencil is then placed over the surface of substrate to be printed, and ink is applied on the screen stencil by means of a squeegee 2. When the squeegee 2 slides across the face of the screen stencil, from one end to the other end, some of the ink goes through the permeable portions of the stencil where the medium is not painted, and is printed onto the substrate below the stencil. The impressions thus produced are an inversed copy of the original pattern.

The screen printing process is well known to be very versatile with a variety of inks. In addition, since the pattern printed comes in thick film ink, the application of a screen printing process is much advantageous where impressions produced are required to have increased anti-weathering characteristics and resistances to chemicals. This printing method had today been universally used in productions of printed circuit (PC) boards and integrated circuit (IC) boards, etc.

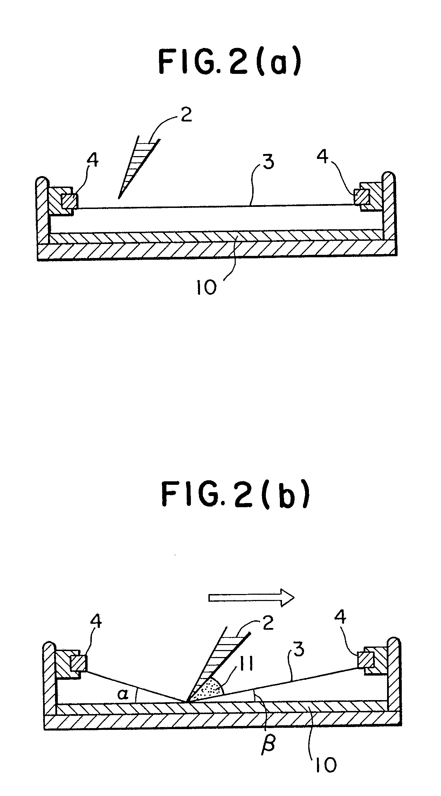

Referring to Fig .2(a) and 2(b), which illustrate an examples of conventional screen printing, Fig. 2(a) is s side cross-sectional view of a frame 4 with a patterned mask on a screen mesh secured in a taut condition to the four sides of the frame. When a squeegee 2 is not pressed down, the stencil lies substantially para-llel to the plane of the surface 10 to be printed, on which the maskis placed slightly spaced apart. When a suqeegee 2 sweeps across thetop face of the ink from one end to the other end, the stencil comes down onto the surface 10, by the pressure of the squeegee. In fact, with the sliding movement of the squeegee 2, the stencil bends into an inverted triangle, as shown in Fig.2(9), with its apex moving across the surface 10. Since the stencil has its opposite ends held infixed positions, the stencil in printing operation must have a physical stretch to a greater length than its original length which the stencil would have when not in printing operation by the pressure of a squeegee 2 as in Fig. 2(a).

It is well known to those versed in the art that the amount of this elongation recudes to the smallest when the moving squeegee 2 passes the mid-point of a stencil in the printing operation. The amount of elongation increases more as the squeegee 2 slides farther away, in either direction, from that mid-point of a stencil. This phenomenon can easily be verified mathematically by the sine theorem.

A number of problems have been known to come from the above-mentioned behavier of the stencil in the prior art screen printing process. With the elongation of the screen, the patterns formed in the stencil have undergone a corresponding stretching.

As a result, the images printed out on their surface 10 have also resulted in a greater dimension than the original size which the screen stencil would restore if the screen stencil are free from the pressure of their squeegee 2. In addition, the elongation in the images has naturally become greater in a bit degree toward either end of the image.

In the prior art, the above-mentioned difficulties have also involved another problems. When the screen stencil in printing operation undergoes an increasing rate of elongation from the center to the end thereof, the tension change which the squeegee 2 develops on the screen stencil must also occur in a correspondingly increasing amount. As a result, the holes in the mesh of the web screen become larger at the both screen ends where tension reaches a maximum greater than that at the screen center where the tension reduces to a minimum. Thus, more ink goes through the screen near its both ends onto the surface 10 than near its center because of the holes enlarged in the mesh. Accordingly, the image printed come with larger dots of ink at its opposite ends than at its center. Furthermore, the disproportional amount of tension developed on a screen stencil with the sweep of the squeegee would easily result in the shorter service life of the stencil.

To summerise, in the prior art screen printing, the images obtained have disproportionate deviations from the pattern intended.

Due to the varying amount of tension developed on the screen stencil caused by their squeegee movement, the screen stencil have shorter life. In addition, the differently expanded holes in the screen mesh have led to producing a poor image lacking in printing quality.

The present invention has been proposed to eliminate the drawbacks of the prior art screen printing machines.

It is therefore a primary object of the present invention to provide an improved screen printing machine in which the screen has one end thereof substantially disposed to slide horizontally for the elastic movement in a direction largely parallel with the plane of the material surface to be printed, and the other end secured in fixed position. With this arrangement, the screen stencil end moves almost horizontally in the direction of the opposite screen end to a more or less degree, so that the effective length of the screen stencil, which is defined as the length of the two inclined stencil surface combined together into the inverted triangle which the screen stencil forms when it is pressed against the material surface to be printed by the squeegee in printing movement, is maintained constant. This also means that the tension which the squeegee develops on the screen stencil remains substantially constant throughout the entire movement of the squeegee across the stencil.

It is a further object of the present invention to provide a screen printing machine in which the snap-off angle (α) in fig 2(b), the angle which the screen forms with the surface to be printed on the opposite side of the ink-holding squeegee side, is maintained constant so that the distribution of ink through the screen onto the material surface is kept uniform.

By contrast, in the prior art machines, this angle α in Fig 2(b) has varied with the sweep of the squeegee across the screen.

BRIEF EXPLANATION OF THE ACCOMPANYING DRAWINGS:

Fig.1 is a perspective view of a screen printing machine;

Fig.2(a) is a schematic side cross-sectional view of the core part of a typycal prior art screen printing machine in a position that the screen, with the pattern painted in it, lies parallel to the surface to be printed, with no squeegee applied to the screen.

Fig.2(b) is a schematic side cross-sectional view of the machine of Fig.2(a) in a position that the screen, along with the pattern in it, is pressed against the surface by the squeegee in printing movement across the screen. In the diagram, α is the snapp-off angle andβ is named as the incident angle for the first time in this patent application.

Fig.3(a) is a schematic side cross-sectional view of a first preferred embodiment according to the present invention in which the screen of a screen printing machine, while having its one end A secured in fixed position, holds the other end B disposed to move resiliently in such a manner that the movable end can extend to a more or less degree with the sweep of the squeegee across the screen;

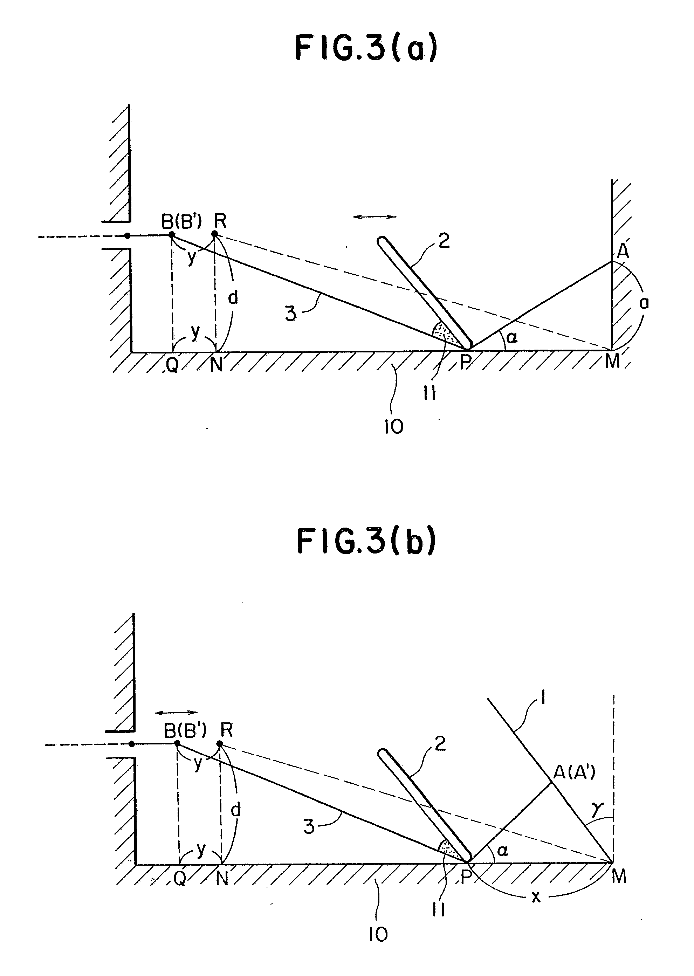

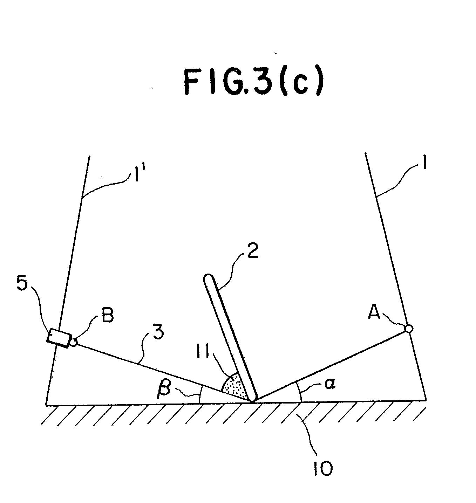

Fig.3(b) is a schematic side cross-sectional view of a second preferred embodiment of the present invention in which the screen has one end A slidably coupled with an inclined guide for linear movement along the bar, with its other end B disposed to move in a similar manner to the end B of Fig.3(a), such that the snap-off angle, formed between the backside of the inclined backside of the screen stencil and the material surface to be printed on the opposite side of the ink-holding squeegee side can be maintained constant, regardless of the position of the squeegee by sliding movement of the end of A linearly synchronizing with the squeegee movement. The movable end A also offers the same result as its counter part in Fig.3(a);

Fig.3(c) is a schematic side cross-sectional view of a third embodiment of this invention in which the screen has its one end A connected to slide in a similar manner as the end A of Fig.3(b) and its other end of B connected to adjusting means connected to a second inclined guide for linear sliding movement along the associated guide such that the angles which the backside of the screen forms with the surface on both sides of the squeegee can be maintained constant, regardless of the position of the squeegee, by movement of the screen stencil ends linearly synchronizing with the squeegee. The adjusting means is also adapted to enable the screen stencil to reach the material surface to be printed without a noticeable fluctuation of the tension the squeegee develops on the screen when it moves across the screen;

Fig.4(a) to 4(d) are each schematic crosssectional view of modifications of the moving mechanism for the screen end B in Figs.3(a) and 3(b);

Fig.5(a) to 5(d) are schematic side crosssectional view of modified versions of the adjusting means shown in Fig.3(c); and

Fig. 6 is a diagram showing the locus of sliding movement of the screen ends A and B along their respective guide in the sweep of the squeegee across the screen stencil.

The present invention is particularly directed to the structure of an improved screen printing machine in which the screen stencil has its one disposed for resilient movement in the direction of its opposite end to a more or less degree depending on the movement of the squeegee so as to keep the tension of the stencil to be constant.

This invention is composed of an improved screen printing machine comprising of a screen stencil, held over a material surface to be printed, of which first end of the two stencil ends to be parallel to the squeegee sides which are perpendicular to its moving direction, is supported to move resiliently on the incident angle formed between the screen stencil surface and the material surface to be printed on the ink holding side of a squeegee according to the squeegee movement across the screen stencil.

The preferred embodiments of the present invention will be described in great detail in conjunction with the accompanying drawings.

Referring to Fig.3(a), the screen stencil 3 of a printer according to the first embodiment of the present invention has one end A thereof fixed securely. The other end B of the screen stencil 3 is disposed for resilient sliding movement in the direction of its opposite end and, at the same time, substantially horizontal to the plane of the material surface 10 to be printed, with the sweep of the squeegee 2 across the screen stencil.

For further detail, the movable end B of the screen stencil 3 moves to a more or less degree automatically to keep the effective length of the screen stencil, defined as the length of the two inclined sides of the triangle which the screen forms when it is pressed against the surface 10 by the tip P of the squeegee 2, is maintained constant throughout the entire printing movement of the squeegee 2 across the screen stencil.

It is important to emphasize that the end B of the screen stencil 3 is made to move in either direction and resiliently in response to the tension which the moving aqueegee develops on the screen stencil. Directional movement of the screen end B in the direction of its opposite end A alone does not provide the above-claimed and other objects of this invention.

In other words, when the squeegee 2 is applied on the screen 3 at its starting point near the screen end A, the screen end B is pulled all way out to the direction of the screen end A. With the squeege 2 moving to the left in Fig.3(a) in printing, the screen end B moves away from the end A. When the squeegee 2 sweeps past the mid-point of the screen, the end B begins to move backward to the direction of its opposite A. Thus, in order for the screen end B to be able to move in either direction, the end B must to be urged in one direction through a proper elastic menans.

With respect to Fig. 3(b), when the squeegee 2 has its tip P located at M, R is the position at which the movable end B of the screen stencil 3 takes. Also, N is the point at which the vertical through R cuts the surface 10. Q is the point at which the vertical through the home position B' of the screen end B, the point where the screen stencil 3 is supposed to have its end B located when the squeegee 2 is at the mid-point of the screen 3, intersects the surface 10. The positional relation of the moving end B of the screen stencil 3 to the squeeg ee 2 can be represented by the following equation :

$$x^2 + a^2 - 2\ell\sqrt{x^2 + y^2} = y^2 + 2y\sqrt{(\ell^2 + d^2)} \quad (1)$$

where y is B'R which is equal to QN, x is PM, 1 is screen length, d is B'Q which is also equal to RN, and a is AM.

It can be establishment from the above that the end B of the screen stencil 3 in this embodiment moves back and forth with the movement of the tip P of the squeegee 2.

Because the screen end B reciprocates in precise response to the movement of the squeegee 2 across the screen stencil 3, the length $(\overline{AP} + \overline{BP})$ of the screen stencil is maintained constant, with the tension the squeegee develops on the screen stenil being also kept constant regardless of the position of the squeegee tip P, unlike the prior art screen printing machines as illustrated in Fig.2.

Furthermore, since the resist pattern formed on the screen 3 does not vary in shape and size, the images the screen imprints on the surface 10 can not only be a precise replica of the pattern, but also can be uiform in ink distribution. In addition, the stability of printing performance can be insured.

This first embodiment of the present invention might be said the simplest which enables the tension the squeegee 2 exerts on the screen stencil 3 to be kept constant. However, in this embodiment, with the movement of the squeegee 2, the snap-off angle α, the angle formed between the backside of the screen stencil and the material surface 10 , varies, because the screen end A is secured in a fixed position. For the screen printer to print images of uniform ink thickness, this snap-off angle must be maintained constant regardless of the position of the moving squeegee 2 on the screen stencil 3.

Referring then to Fig. 3(b), a screen printing machine according to the second embodiment of the present invention has a screen 3 having one end A thereof connected to slide to an inclined straight guide 1 for the linear movement along the guide 1 in unison with the squeegee 2 movement, so that the snap-off angle α is maintained constant. The other end B of the screen is connected to move in a substantially similar manner as its counterpart explained in connection with Fig. 3(a), which will not be described here for the sake of brevity. In the description which follows, reference characters B' , M,N, Q, and R are used to indicate as have been employed in Fig. 3(a). A' is the point the screen end A takes in its movement along the guide.

For more detail, to keep the snap-off angle α to be constant, regardless of the position of the squeegee tip P on the screen stencil , the screen end A must be moved in such way that the radio of PM to $\overline{A'M}$ is a constant value throughout the squeegee range.

Because the $\overline{PM}$ to $\overline{A'M}$ radio is constant regardless of the positions of moving A' and P, the angle α between $\overline{A'P}$ and $\overline{PM}$ remains unchanged.

That is, all triangles formed by the moving points A' and P in conjunction with M are always similar with one another, independent of the position of the squeegee 2 on the screen stencil 3.

The relation of the angle α with the movement of the squeegee 2 across the screen stencil 3 in Fig. 3(b) may be expressed by the following equation:

$$\{1-\cos 2\gamma/\cos 2(\alpha - \gamma) \} (x^2 + y^2) + 2\{ \sqrt{\ell^2 - d^2} + \ell \cos \gamma/\cos(\alpha - \gamma) \} x - 2\sqrt{\ell^2 - d^2}\, y - 2xy = 0 \quad (2)$$

where x is $\overline{PM}$, y is $\overline{RB}$ which is equal $\overline{NQ}$, 1 is the entire length of the screen stencil 3 from the end A' to the other end B through the squeegee tip P, d is $\overline{B'Q}$ which is equal to $\overline{RN}$, and γ is the angle between the plane of the guide 1 and the vertical through M to material surface to be printed.

The equation (2) above is quadratic and describes a hyperbolic or elliptical curve upon planes x and y.

Hence, introducing the sine theorem into this embodiment gives:

$\overline{A'P}/\sin \angle A'PM = \overline{PM}/\sin \angle PA'M$

$\therefore A'P/\sin (90° - \gamma) = PM/\sin(90° - \alpha + \gamma)$

$\therefore A'P = x\cos \gamma/\cos (\alpha - \gamma)$

$= x/( \cos \alpha + \sin \alpha \cdot \tan \gamma)$

It menans that, for a given distance of x or $\overline{PM}$, $\overline{A'P}$, the distance between the slidable screen end A the tip P of the squeegee 2 on the screen stencil 3 becomes smaller if the angle γ is taken greater.

The more the angle γ is greater than α/2 , the finer the images, which the screen stencil 3 prints on the material surface 10, would become because of the movement of the squeegee 2. On the other hand, if the angle γ is taken smaller than α/2, the A'P or the distance between the squeegee tip P and slidable screen end A relative to the distance x ($=\overline{PM}$) becomes greater. As a result, the images printed would be finer.

With the preffered embodiment shown in Fig. 3(b), not only that the snap-off angle α can be maintained constant, but also the angle γ , which the guide 1 forms with the vertical plane to the material surface through point M may be adjusted so as to provide for enhanced printing quality.

Particularly when γ = α/2, then ∠ PMA' = 90° - α/2.

From this expression , Δ PA'M is a isosceles triangle, because of $\overline{PA'}$ being equal to $\overline{PM}$.

This particular embodiment is as follows.

According to the movement of the squeegee tip P across the screen stencil 3, the distace x (or $\overline{PM}$) changes in propotion to the change of $\overline{A'P}$ this means that the time difference of x, which is difined as dx/dt on the material surface to be printed, is equal to the time difference of $\overline{A'P}$, which is difined as $d\overline{A'P}$/dt on the stencil surface.

The speed (dx/dt) at which the squeegee 2 runs at its tip P across the screen stencil surface is entirely the same rate at which the apex of the triangle formed by the stencil surface in contact with the material surface to be printed sweeps along the stencil 3.

If the rate of speed $d\overline{A'P}$/dt at which $\overline{A'P}$ moves is not equal to the speed dx/dt at which the tip P of the squeegee 2 sweeps across the screen stencil 3, then it means that the apex of the triangle the screen stencil 3 forms in contact with the surface 10 to be printed is not moving across the surface at the same speed.

That is, the relation that dx/dt is equal to $\overline{A'P}$/dt can be established.

This expression is meant by the explanation that the relative elocity of the apex P to a supposed point on the screen stencil surface 3 is entirely the same one to a supposed point on the material surface to be printed 10.

This fact lead us to the next conclusion that there is no difference between the velocities, so any slip between the back-surface of the screen stecil and the material surface 10 to be printed.

Here we can get the absolute dimension screen printer which promises us the entirely same print as the original pattern on the master mask.

When $\gamma = \alpha/2$, it can be established that $\overline{PA'}$ is equal to PM. Accodingly, the speed of the squeegee tip P when it moves along the screen stencil surface, which is defined as dx/dt, is equal to the speed of $\overline{A'P}$ which is difined as $d\overline{A'P}$/dt. It also means that the apex of the triangle that the screen stencil 3 forms in contact with the surface 10 moves across the material surface at the same speed.

Since the pattern coated on the screen stencil 3 is made to sweep across the surface 10 at a uniform rate of speed, the images formed on the surface would be faithful replicas to the pattern on the screen stencil.

In this case, the preferred embodiment must satisfy the following equation :
$$x = y/2 - \sqrt{\ell^2 - d^2} + \ell + d^2/2 (y - \sqrt{\ell^2 - d^2} + \ell)$$

Also, the screen stencil 3 of the present embodiment has its other end B disposed to move in a similar manner as the previous embodiment described with respect to Fig.3(a), in order to maintain constant the effective length of the screen stencil and tension which the squeegee 2 develops or the screen stencil. Because of this, this embodiment can insure uniform printing and precise reproduction from the original pattern with stability.

Furthermore, since the snap-off angle $\alpha$ can be maintain to be constant, the umiformity of ink thickness can be insured.

As stated above, the prefrerred embodiment shown in Fig.3(b) can ensure extremely excellent printing quality, because the snap-off angle $\alpha$ and

the tension the squeegee 2 exerts on the screen stencil 3 can be kept constant.

Referring then to Fig.3(c), the screen stencil 3 of a third preferred embodiment of this invention has one end (A) thereof slidably connected on an inclined guide 1 in a substantially similar manner as its counterpart in Fig.3(b) in order to maintain constant the snap-off angle $\alpha$ which the backside of the screen stencil forms with the surface 10 on the side of the guide 1. Also, the opposite end B of the screen stencil 3 is connected to slide to a second guide 1' for the movement along the guide 1' in synchronization with the squeegee 2 movement across the screen stencil so as to deep constant the incident angle $\beta$, which backside of the screen stencil forms with the surface on the side of the guide 1'.

For the screen stencil 3 to simultaneously keep fixed its entire effective length L, the snap-off angle $\alpha$ and the incident angle $\beta$, the guides 1 and 1' each have to be so designed that the following equations are satisfied at the same time:
$$x1 - x2 = y1 \cot\alpha + y2 \cot\beta \quad (5)$$
$$y1 \csc\alpha + y2 \csc\beta = L \quad (6)$$

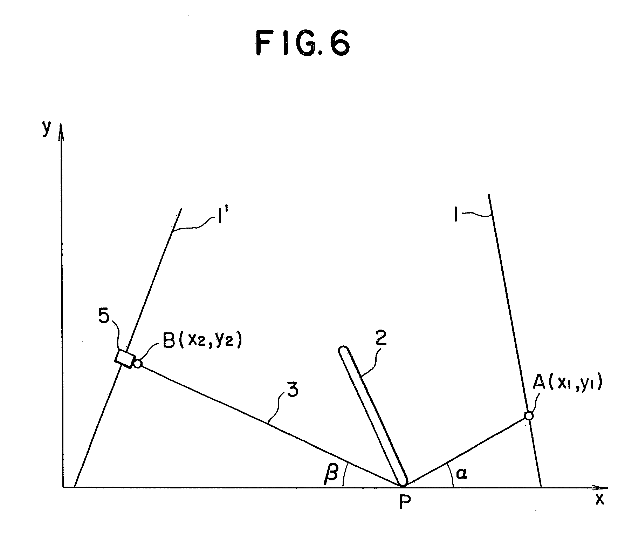

Where (x1,x2) is the locus that the screen stencil end A describes when moving along its guide 1' in the coordinate shown in Fig.6, and (x2,y2) is also the locus that the other screen stencil end B traces in movement along its guide 1'. Both in linear synchronization with the squeegee tip P (t, 0).

When the ends A and B of the screen stencil 3 move along their respective guides 1 and 1' in linear synchronization with the sweep of the squeegee 2 across the screen stencil so as to simultaneously maintain constant the length of the screen stencil, which is defined as the distance of A'P and PB added together in Fig.3(c), the snap-off angle $\alpha$ and the incident angle $\beta$, the present preferred embodiment must virtually be considered to provide excellent printing performance in terms of faithful reporutction from the original pattern painted in the screen stencil 3.

However, the movement of the screen stencil ends A and B along their respective guide in synchronization with the squeegee may result in the screen stencil 3 not always maintaining constant the tension the squeegee 2 develops on the screen stencil, because of the following :

1. Error involved with respect to possible change in thickness of the surface 10.

2. Error in synchronization that the ends A and B of the screen stencil 3 takes with each other.

In order to improve these difficulties, holding means 5 is provided, which is slidably engaged with the guide 1' for the regilient movement along the guide. The end B of the screen stencil 3 is movably connected to the holding means 5, as shown in Fig.3(c).

The holder means 5 also serves to offset any change in the tension with the squeegee 2 develops on the screen stencil 3 to thereby maintain constant the snap-off angle $\alpha$ and the incident angle $\beta$. As a result, faithful reproduction, uniformness in ink thickness and printing stability can be obtained.

Various modifications of the means for holding the end B of the screen stencil 3 to move resiliently will be described.

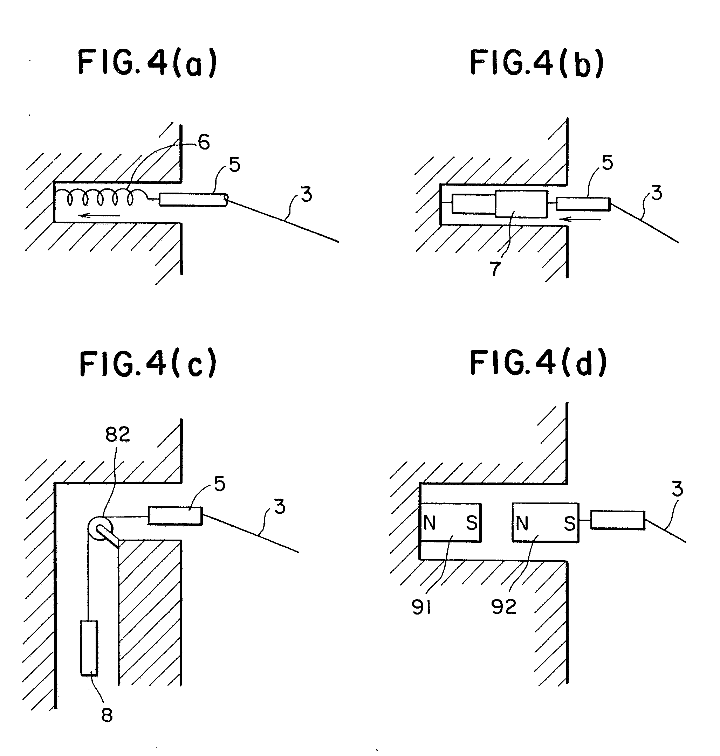

Fig.4(a) to Fig.4(d) are respectively views of different versions of the means for holding the end B of the screen stencil to move resiliently as shown in Fig.3(a) and 3(b). Each modification is designed to hold the end B of the screen stencil to move resiliently in such a manner that the end extends in the direction of the screen stencil to more or less degree depending on the tension the squeegee exerts on the screen stencil.

The modification of the holder means 5 depicted in Fig.4(a) comprises rod 5 which is connected at one end thereof to one end of a compression spring 6. Also, the rod 5 is connected at its other end to the end B of the screen stencil 3. The spring 6 is secured at its opposite end to a fixed surface.

In Fig.4(b), the holder means comprises a rod 5 connected at one end thereof to the end B of the screen stencil 3 and at its opposite end to the reciprocating piston 7a of a pneumatic cylinedr 7 which in turn is fixedly secured at its rear end. The cylinder 7 in this embodiment is a type in which the piston 7a is urged into the bore of the cylinder.

The holder means illustrated in Fig.4(c) is also a rod 5 tied at one end thereof to a weight 8 with a string 81 that is passed around a pulley 82 in such a manner that the rod 5 is movable back and forth. The rod 5 is connected at its opposite end to the B of the screen stencil 3. The weight 8 unges the rod 5 in the direction opposite to the other screen end A. In an alternative version, the pulley 82 may be omitted.

With respect to Fig.6(d), the modification is a rod 5 connected at one end thereof to a pair of fixed magnet 91 and a freely supported magnet 92 to which the end B of the screen stencil 3 is linked through the rod. With this arrangement, magnetic attraction between the paird magnets 91 and 92 urges the screen stencil end B in the direction opposite to the other screen stencil end A.

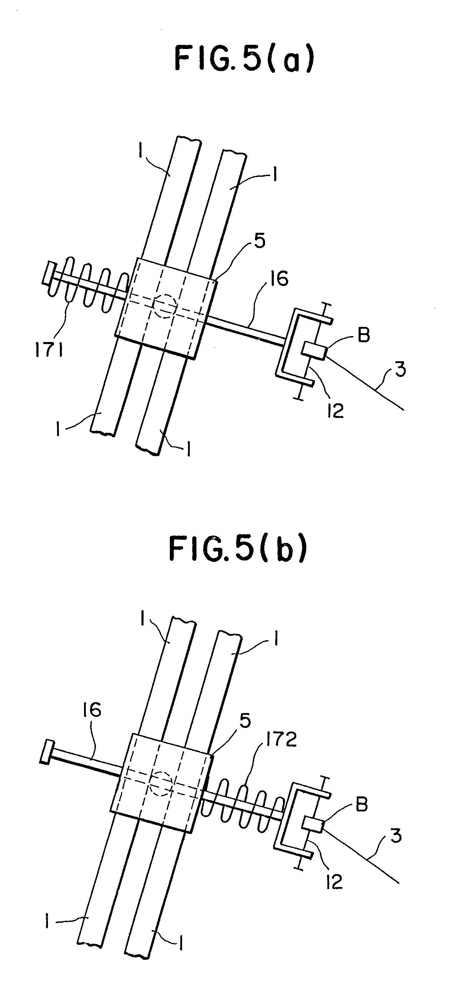

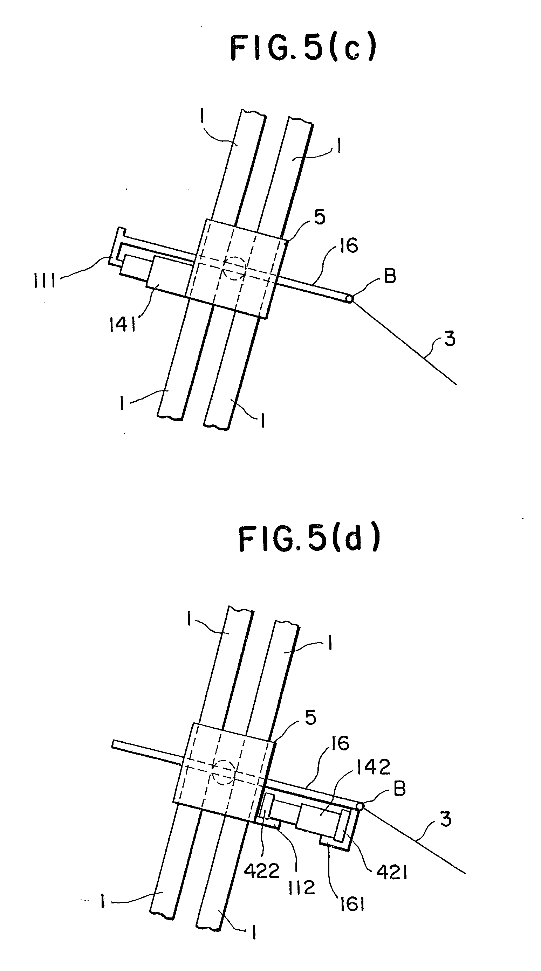

Fig.5(a) to 5(d) are respectively modeified forms of the holder means 5 for movably holding the end of the screen stencil 3 slidably disposed in the guide 1' for free movement along the guide as described in connection with Fig.3(c).

The holder means 5 depicted in Fig.5(a) comprises a movably disposed rod 16 having connected at one end thereof on the end B of the screen stencil 3. The holder means 16 has a hole bored t carry therein the rod 16 in such a manner that the rod can move back and forth freely in the hole. A compression spring 171 is mounted about the rod 16 on the opposite side of the guide 1' to the screen stencil end B in such a manner that the rod 16 is elastically urged in the direction opposite to the screen other end A.

With respect to Fig.5(b), the holder means 5 is very similar to the version of Fig.5(a), except for a compression spring 172 which is installed about the rod 16 on the same side of the guide 1' as the screen stencil end B. The spring 172 is provided to provide the same effect as the spring 172 of Fig.5(b).

Alternatively, each of the modeifications of the holder means 5 shown in Fig.5(a) and 5(b) may replace the compression spring for an elastic rubber member which may be mounted around the rod 16 in such a manner as to urge the screen stencil end B in the direction opp osite to the other end A of the screen stencil.

In Fig.5(c), the holder means 5 comprises a pneumatic cylinder 141 having a reciprocable push rod 141a to which a rod 16 is engaged. The cylinder 141 in this embodiment is a type in which the rod 141a is urged against to cylinder. The holder means 5 has a hole bored to carry the rod 16 in such a manner that the rod can move back and forth freely in the hole. The cylinder 141 is installed on the opposite of the bar 1' to the screen stencil end B to urge the rod 16 in the direction opposite to the other screen stencil end A. The rod 16 may be provided with a projection 111 to engage with the push rod 141a of the cylinder 141.

With respect to Fig.5(d), the holder means 5 is very similar to the version shown in Fig.5(c), except for a pneumatic cylinder 161 which is installed on the same side of guide 1' as the screen stencil end B. Also, the cylinder 142 is a type in which the piston 142a is urged inwardly into the cylinder bore. The rod 16 is engaged to the reaward end of the cylinder 421, with its reciprocating piston 142a being held against the guide 1'. The arrangement is provided to produce the same effect as the one in Fig.5(c). The cylider 142 may be provided at opposite ends thereof with a pair of flanges 421 and 422. Also, the rod 16 may be provided with a projection 112 to engage with the flange 421. The holder means 5 may be provided with a hook member to engage with the flange 422.

In each of the modifications described in association with Fig.5(c) and 5(d), although the peumatic cylinder is employed, this is a matter of choice. Any similar vacuum operated or hydraulic cylinder or other system may be used if it is capable of urging the rod 16 in the direction opposite to the end A of the screen stencil 3.

In addition, in each modification shown in Fig.5(a) and 5(b), the end B of the screen stencil 3 is connected to the holder means 5 through a pin 12 in such a manner that the end B is freely slidable in direction parallel with the guide 1'. By contrast, the modified versions in Fig.5(c) and 5(d) show that the screen stencil ends B are directly connected to thier respective holder means 5. Needless to say, the methods of connection shown are give by means of illustration, and should not be considered to limit the invention. Any known means may be used to connect the holder means 5 to the screen stencil end B.

The embodiment shown in Fig.3(c) is designed to correct the following errors:

    1. vertical displacement in the surface to be printed, and

    2. failure of synchronization between the screen stencil ends A and B in movement along their respective guides 1 and 1'

In the prior art screen printing machines, these errors would lead to a change in the entire effective length of the screen stencil and hence the tension change that the squeegee develops in the screen.

However, the embodiment can counter these errors because means is provided to automacically adjust the incident angle to keep constant the tension in the screen.

As stated above, since the preferred embodiment of Fig.3(c) can maintain fixed the snap-off angle α, the incident angle β and the tension the squeegee develops in the screen, faithful reproduction of printed images from the pattern in the screen and excellent printing performance can be obtained.

It will be easily appreciated from the above that the present invention holds the ends of the screen stencil resiliently movable in such a manner that the tension the squeegee exerts in the screen stencil printing operation can be maintained constant. Also, the invention includes other means which coorperate with the movably supported screen stencil end A to keep the snap-off angle constant. In the other emdobiments of the invention, means are provided to maintains fixed both the snap-off and the incident angles (Fig.3(d)). These features help enable the present invention to offer extremely improved printing perfornce.

Since the present invention can insure uniformity in ink thickness and faithful reproduction of printed images from the screen stencil pattern, it can be used in production printed ICs.

In addition, since the tension the squeegee develops in the screen stencil service can be insured. As a result, the present invention can also contribute to reducing costs.

## Claims

1 : An improved screen printing machine comprising of a screen stencil, held over a material surface to be printed, of which first end of the two stencil ends to be parallel to the squeegee sides which are perpendicular to its moving direction, is supported to move resiliently on the incident angle formed between the screen stencil surface and the material surface to be printed on the ink holding side of a squeegee according to the squeegee movement across the screen stencil.

2 : A screen printing machine as set forth in Claim 1, wherein the second stencil end on the side of snap-off angle which is opposite to the first screen stencil end is fixed tightly.

3 : A screen printing machine as set forth in Claim 1, wherein the second stencil end is slidably connected to a straight guide which is inclined from the normal direction to the material suface to be printed, and to which the stencil end or stencil holder moves along proportionally to the speed of a squeegee moving across the screen stencil.

4 : A screen printing machine as set forth in Clim 3, wherein the inclined angle formed between the said guide and the normal direction to the material surface to be printed is a half of the snap-off angle.

5 : A screen printing machine as set forth in Claim 2 or 3, wherein the first stencil end is provided with a spring connected to both the stencil holder and the spring holder fixed securely on the said screen printing machine, the said spring being installed to elastically move the frist end of the screen stencil so as to keep the tension, caused by the squeegee movement across the screen stencil, to be constant.

6 : A screen printing machine as set forth in Claim 2 or 3, wherein the first stencil end is provided with a air or vacuum cylinder in stead of the said spring connected to both the stencil holder and the said cylinder holder fixed securely on the said screen printing machine, the said cylinder being installed to elastically move the first end of the screen stencil so as to keep the tension, caused by the squeegee movement across the screen stencil, to be constant.

7 : A screen printing machine as set forth in Claim 2 or 3, wherein the first stencil end is provided with a weight, in stead of the said spring, connected to the stencil or its holder by means of the weight holder fixed securely on the said screen printing machine, the said wieght being installed to eastically move the first end of the screen stencil so as to keep the tension, caused by the squeegee movement across the screen stencil to be constant by changing its position in the perpendicular direction.

8 : A screen printing machine as set forth in Claim 2 or 3, wherein the first stencil end is provided with a elastic material connected to both the stencil or its holder and the elastic material holder fixed securely on the said screen printing machine, the said elastic material being installed to elastically move the first end of screen stencil so as to keep the tention, caused by the squeegee movement across the screen stencil, to be constant.

9 : A screen printing machine as set forth in Claim 2 or 3, wherein two magnets are provided as a elastic means for the elastic movement of said first stencil end so as to keep the tention, caused by the squeegee movement across the screen stencil, to be constant.

10: A screen printing machine as set forth in Claim 1, wherein the first screen stencil end and the second stencil end or their holders parallel to the squeegee sides are connected to their straight guides respectively for proportional movement of both the first stencil end along the first guide and the second stencil end along the second guide respectively to the movement of the squeegee so as to keep both the incident angle and the snap-off angle to be constant, the former incident angle is formed between the stencil surface and the material surface to be printed on the ink-holding side of the squeegee, and the latter snap-off angle thus formed between them on the opposite side of the ink holding side of the squeegee, to be consatant, the first screen stencil end being supported to move resiliently on the incident angle side according to the squeegee movement in the printing opration.

11: A screen printing machine as set forth in Claim 10, wherein the inclined angle formed between the said first guide and the normal direction to the material surface to be printed on the incident angle side is a half of the incident angle and the incident angle formed between the said second guide and the normal direction to the material surface to be printed on the snap-off angle side is a half of the snap-off angle and both screen stencil ends can move up and down fluently so as to keep the snap-off angle and the incident angle to be constant in the printing operation.

12: A screen printing machine as set forth in Claim 10 or 11 wherein a spring is provided between the first screen stencil end and its holder on the said screen printing machine, to which spring the first stencil end is connected, the said spring is adapted to move the first stencil end elastically so as to keep the tension, caused by the squeegee movement across the stencil in the printing operation.

13: A screen printing machine as set forth in Claim 10 or 11 wherein a elastec material is provided between the first screen stencil end and its holder, to which material the first stencil end is connected, the said elastic material is adapted to move the first stencil end elastically so as to keep the tention, caused by the squeegee movement across the stencil in the printing operation.

14: A screen printing machine as set forth in Claim 10 or 11 wherein a pneumatic cylinder means is provided between the first screen stencil end and the holder, to which the first stencil end is cnnected, the pneumatic cylinder means is adapted to move the first stencil end elastically so as to keep the tention, coming from the squeegee movement across the stencil in the printing operation.

# FIG. 1

# FIG.2(a)

# FIG.2(b)

# FIG.3(a)

# FIG.3(b)

# FIG.3(c)

# FIG.4(a)

# FIG.4(b)

# FIG.4(c)

# FIG.4(d)

# FIG.5(a)

# FIG.5(b)

## FIG.5(c)

## FIG.5(d)

# FIG.6